# FASCICULE DE BREVET EUROPEEN

(11) **EP 0 333 550 B1**
(45) Date de publication et mention de la délivrance du brevet: **20.01.1993**
(21) Numéro de dépôt: 89400602.2
(22) Date de dépôt: 03.03.1989
(51) Int. Cl.: H05K 1/00, H05K 3/02

(54) **Procédé de réalisation de circuits imprimés sur un support plastique tridimensionnel, et support ainsi équipé**
Verfahren zur Herstellung von gedruckten Schaltungen auf einem plastischen dreidimensionalen Träger und so hergestellter Träger
Process for producing printed circuits on a three-dimensional plastic carrier, and carrier so equipped

(30) Priorité: 11.03.1988 FR 8803184
(43) Date de publication de la demande: 20.09.1989
(73) Titulaire: THOMSON-CSF, 75008 Paris (FR)
(72) Inventeur: Leblanc, Claude, F-92402 COURBEVOIE CEDEX (FR); Hulot, Michel, F-92402 COURBEVOIE CEDEX (FR)
(74) Mandataire: Benoit, Monique

(56) Documents cités:
- FR-A- 932 898
- FR-A- 1 566 978
- FR-A- 2 516 740

## Description

La présente invention concerne un procédé de réalisation de circuits imprimés sur plusieurs surfaces sécantes, planes ou courbes d'un support thermoplastique ou thermodurcissable, ainsi qu'un dispositif équipé de tels circuits.

L'invention se rapporte plus particulièrement à des dispositifs comportant une architecture mécanique en matériau plastique comme support de fonctions électroniques, qui présente notamment une surface cylindrique sur laquelle les techniques courantes de réalisation des circuits imprimés plans sont difficilement utilisables.

Les circuits plans nécessitent un système de fixation des cartes adapté aux contraintes mécaniques de la pièce support en exploitation, et un système d'interconnexion entre circuits par rapport aux blindages et vis-à-vis de l'extérieur.

Ces circuits plans sont particulièrement difficiles à introduire dans des volumes réduits de formes complexes. Ils augmentent le nombre de pièces et donc souvent le temps d'assemblage ; ils occupent du volume et participent à la diminution de la fiabilité. Les problèmes de protection (étanchéité, blindage électromagnétique, agression chimique extérieure) viennent se greffer et doivent être traités en plus des précédents.

Les supports plastiques présentent un intérêt du fait qu'ils sont faciles à produire par injection ou transfert. Ils sont de plus faciles à usiner et présentent une faible densité.

Les surfaces de ces supports thermoplastiques ne sont pas forcément planes et dans ces cas les techniques usuelles utilisées pour les circuits imprimés plans, telle que la photographie, ne peuvent être mises en oeuvre. Il est difficile également d'avoir une continuité électrique très fiable entre des surfaces planes ou courbes via les arêtes d'intersections linéaires, circulaires, ou courbes, de ces surfaces non coplanaires qui reçoivent chacune un circuit imprimé.

En outre, pour des contraintes mécaniques importantes, par exemple une rotation à grande vitesse, les éléments sont soumis à des forces centrifuges élevées qui peuvent être assimilées à des chocs et il y a risque de décollement ou rupture des pistes conductrices par suite du poids des composants soudés sur les circuits imprimés et de rupture également au niveau des interconnexions entre circuits.

Pour effectuer un circuit imprimé sur une surface courbe, par exemple cylindrique, on procède selon des techniques connues à l'enroulement d'un circuit plat sur le cylindre, son collage, son interconnexion et ensuite à l'apport des composants. Les inconvénients qui en résultent sont les imprécisions de positionnement du circuit compte tenu des tolérances d'usinage du cylindre, de l'épaisseur de la colle, etc..., ce qui entraîne une différence de position entre le circuit cylindrique et des circuits plats portés sur les surfaces planes connexes à la surface cylindrique. En conséquence, la fabrication en série n'est pas fiable par une telle solution. Un autre inconvénient est que les interconnexions ne sont pas assurées entre les circuits plans des surfaces planes et le circuit enroulé sur la surface cylindrique, ce qui nécessite l'utilisation de fils de câblage et consécutivement une manutention, un coût et une fragilité plus élevés et une fiabilité encore plus réduite. La soudure des fils au fer à souder risque de faire fondre le support dans le cas d'un thermoplastique, la température du fer étant de l'ordre de 250 à 300°C environ.

Il est également connu par la demande de brevet français FR-A- 1.566.978 de réaliser un circuit imprimé par impression directe ou tampographie, sur un support plan présentant des irrégularités de surface minimes, ou encore, par le demande de brevet français FR-A- 2.516.740 de réaliser des zones électriquement conductrices sur un support cylindrique à l'aide d'un cylindre d'impression opérant par roulement.

Cependant, le problème de réaliser des circuits imprimés sur des surfaces cylindrique et planes sécantes avec coïncidence des raccords d'interconnexion subsiste.

Le but de l'invention est de remédier aux divers inconvénients signalés en réalisant, de manière particulière, les circuits imprimés portés par la surface courbe et les surfaces planes sécantes , ainsi que les interconnexions ces circuits.

Elle a pour objet un procédé de réalisation de circuits imprimés par tampographie sur un support plastique comportant une surface cylindrique et des surfaces planes délimitant une pièce cylindrique. Selon ce procédé, l'impression par tampographie s'effectue à l'aide de plusieurs tampons dont au moins un tampon pour imprimer la surface cylindrique opérant par roulement et un tampon pour imprimer une surface plane opérant par tamponnement, des éléments de la pièce cylindrique étant utilisés comme repères de positionnement pour les tampons de manière à faire coïncider entre eux les raccords d'interconnexion des circuits imprimés revêtant des surfaces sécantes.

Suivant une autre caractéristique de l'invention, les surfaces du support plastique sont mises en état avant impression au moyen d'une attaque chimique qui produit de fines craquelures augmentant l'adhérence du cuivre déposé et évitant toute rupture du circuit imprimé équipé de ses composants, en particulier sous l'effet de la force centifuge.

Suivant encore une autre caractéristique, le report des composants est effectué en les soudant en phase vapeur à une température bien déterminée supportée par le matériau thermoplastique.

Les particularités et avantages de l'invention apparaîtront dans la description qui suit donnée à titre d'exemple, à l'aide des figures annexées qui représentent :
- Fig. 1, un exemple de support thermoplatique équipé de circuits imprimés obtenus selon un procédé conforme à l'invention ;
- Figs. 2 et 3, le même support que celui de la figure 1, en cours d'exécution, pour illustrer les différents types de connexion réalisés ; et
- Fig.4, un schéma de l'impression par tampographie utilisée selon l'invention, sur une pièce cylindrique.

Le procédé de réalisation du circuit destiné à la surface courbe comporte de manière habituelle des opérations de mise en état de surface préalablement au cuivrage et à l'impression et ensuite au report des composants sur la surface imprimée.

Les opérations de surfaçage produisent notamment, par attaque chimique, des craquelures fines, par exemple de l'ordre du micron. Ce surfaçage assure ensuite une tenue mécanique très élevée aux pistes du circuit imprimé, généralement en cuivre étamé, auxquelles sont soudés les composants. Il empêche le décollement des pistes et des composants lorsqu'ils sont soumis à une force centrifuge élevée, ce qui est le cas notamment pour une pièce support cylindrique entraînée en rotation à grande vitesse autour de son axe ou accélérée le long de son axe.

Les opérations de surfaçage comportent, selon des techniques connues, différentes phases qui sont rappelées ci-après : dégraissage, étuvage à une température donnée pendant une durée donnée, sèchage, décapage, rinçage, trempage dans un mélange chimique pour produire une attaque, rinçage et neutralisation, etc ...

Le circuit imprimé est réalisé selon les opérations suivantes :
- cuivrage par dépôt de cuivre chimique sur le substrat non conducteur et renforcé par du cuivre électrolytique pour produire une couche de cuivre de 7 à 10 microns d'épaisseur ;
- dépôt par tampographie d'une encre ou d'une résine photosensible insolable au laser (les opérations de tampographie seront décrites ultérieurement avec des exemples de réalisation de circuits imprimés voisins déposés sur des surfaces planes) ;
- étamage au-dessus du cuivre ;
- retrait de l'encre ou de la résine ;
- attaque du cuivre non protégé par l'étain.

Il reste la dernière phase qui est le report des composants sur les circuits imprimés portés par la surface courbe et les surfaces planes. Ce report peut être produit pour une surface cylindrique par un système robotisé utilisant un moteur pas-à-pas.

La solidarisation des pattes des composants avec le circuit imprimé correspondant s'effectue en phase vapeur en utilisant un composant fluorocarboné. Par exemple, avec le composant connu sous la marque "Fluorinert" FC 70, ou un composant équivalent, on peut obtenir une température de la phase vapeur bien précise de 215°C ± 3°C ,température qui est bien supportée par le matériau thermoplastique du support.

La technologie d'exécution utilisée nécessite le choix d'un plastique de grande stabilité dimensionnelle jusqu'à la température de brasure des composants, par exemple parmi les suivants : polyethersulfone, polysulfone, polyétherimide, polyétherether cétone, polyphénylène sulfure, polyimide chargés ou non chargés, et thermodurcissables (époxydes par exemple).

Les composants utilisés pour la circuiterie sur les différentes surfaces sécantes sont des composants pour montage en surface de type passif ou actif utilisés habituellement pour des circuits imprimés plats. Ils sont reportés sur les zones courbes de l'architecture mécanique dans la limite des compatibilités selon les dimensions des composants et les rayons de courbure de la pièce. Un outillage spécifique du type précité peut être conçu et réalisé pour la pose des composants sur ces surfaces.

Cet outillage a pour base une machine de report automatique de composants sur circuits plats gérée par un micro-ordinateur et à laquelle est adjoint :
- un dispositif support de pièce qui permet son orientation, par exemple au dizième de millimètre près pour conserver la même précision que sur un circuit plat ;
- une tête support de seringue pour le dépôt de la colle de maintien des composants ; et
- une tête support de seringue pour le dépôt de la pâte à souder.

Cet ensemble peut être géré par le micro-ordinateur de la machine qui commande donc : les déplacements de la table Y ; la rotation du support de pièce ; le déplacement des têtes pour la colle et la pâte à souder ainsi que les instants de dépose et les pressions et durées. La fixation de la pièce sur son support se fait, comme sur la machine à tampographier, à l'aide des mêmes éléments de référence de position angulaire.

La pièce support comportant une surface courbe, par exemple cylindrique, comporte des surfaces planes généralement perpendiculaires à l'axe du cylindre ou axe d'entraînement en rotation de la pièce. Sur ces surfaces planes on produit également des circuits imprimés plans cette fois et pouvant recevoir des composants, ces circuits plans devant être interconnectés avec le circuit imprimé sur la face courbe.

Conformément à l'invention les circuits et leurs interconnexions sont réalisés avec précision en effectuant une impression par tampographie avec plusieurs tampons.

Le procédé d'impression par tampographie est un procédé d'impression indirect en creux. L'image à imprimer se trouve représentée à l'endroit sur un cliché gravé en creux. Après passage d'un racloir l'encre reste dans les creux de la gravure. Un tampon en silicone constituant l'organe de transfert est appliqué sur la gravure. Il s'encre sur le cliché et permet ainsi de transférer ensuite l'image sur l'objet à marquer.

Pour un objet plan, on peut procéder de la manière suivante :
- le cliché est une plaque en acier trempé gravé sur une profondeur de 25 microns. Ce cliché plan est recouvert d'encre par un premier racloir qui prélève de l'encre dans un encrier ;
- au retour une racle débarrasse la surface du cliché de l'encre en excès qui ne reste donc que dans les parties gravées en creux ;
- le tampon en silicone est amené au-dessus du cliché, appliqué contre l'image gravée et encrée et prélève ainsi l'encre dans les creux de la gravure ;
- le tampon est ensuite déplacé au-dessus de l'objet plan à marquer et est posé sur la pièce qui est ainsi imprimée. Le dessin se trouve reproduit à l'endroit sur la pièce. Toute l'encre absorbée par le tampon a été ainsi pratiquement reportée sur la pièce. La surface de la pièce peut être difficile à imprimer avec les procédés habituels mais le tampon qui est en matériau élastique et compressible imprime parfaitement les contours et permet une parfaite reproduction. La forme du tampon peut être sensiblement conique, le sommet du tampon étant amené sensiblement en coïncidence avec le centre du dessin à reproduire.

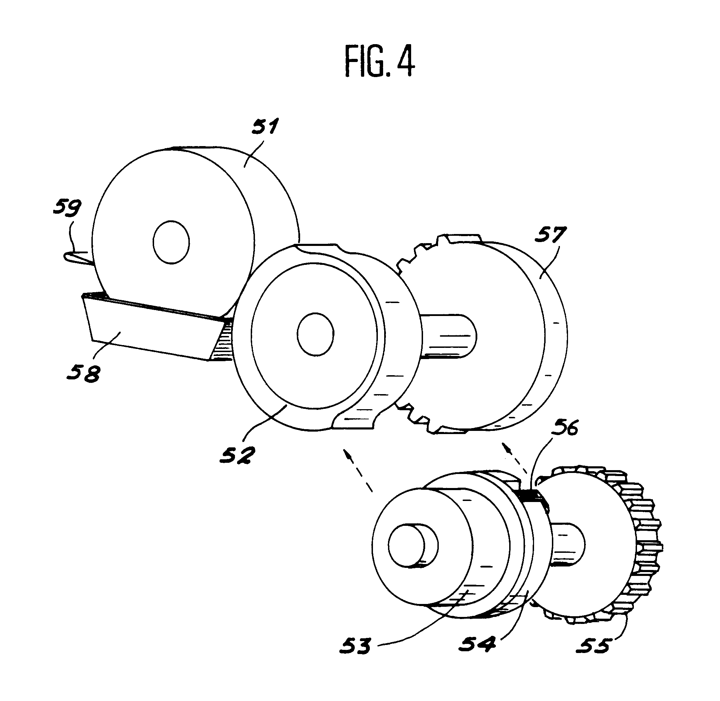

Dans le cas d'une reproduction sur une pièce cylindrique le principe reste le même mais le cliché et le tampon sont également cylindriques. Le mode opérationnel illustré par la figure 4 est le suivant :
- le cliché cylindrique 51 est recouvert d'encre au passage dans un encrier 58 ;
- une racle 59 débarrasse l'excès d'encre de façon à ce qu'il ne reste que l'encre nécessaire à l'impression dans les parties gravées en creux ;
- le cliché 50 vient ensuite déposer l'encre sur le tampon 52 par rotation relative de ces éléments ;
- le tampon 52 est ensuite déplacé au niveau de la pièce 53, ou inversement, et les rotations de ces éléments produisent le transfert de l'encre et l'impression à l'endroit du dessin sur la pièce.

Ces techniques sont mises en oeuvre dans l'invention et la coïncidence entre les circuits imprimés réalisés sur les surfaces planes et ceux réalisés sur la surface courbe par exemple cylindrique est assurée pour les raisons suivantes :
La pièce comporte des éléments de repérage de sa position angulaire, par exemple la patte 56 de contactage. Le circuit plat est imprimé en se servant de ce repère pour l'orienter. Lorsqu'on imprime sur le cylindre de la pièce 53, le porte pièce 54 constitué d'un mandrin et de son pignon d'entraînement coaxial 55, utilise le même élément 56 pour le positionnement angulaire de la pièce, que celui utilisé pour le circuit plat, ainsi qu'une orientation de départ parfaitement définie.

Le tampon de report de l'image 52, est constitué d'un secteur en silicone couplé sur le même axe à un secteur denté 57. Le nombre de dents du secteur denté, est égal à celui du pignon 55 d'entraînement du porte pièce 54. Le pignon 55 fait donc un tour exactement pendant son entraînement par le secteur denté.

Un ajustement précis de l'orientation du tampon 52 par rapport à celle du secteur denté 57 (ils sont sur le même axe), permet d'obtenir un dépôt d'encre parfaitement orienté angulairement sur la pièce.

Il y a lieu de remarquer que la précision est angulaire, ce qui permet d'avoir une image se rebouclant correctement sur la pièce indépendamment des écarts sur son diamètre.

Dans le cas particulier d'un circuit imprimé en trois dimensions, l'encre tampographiée doit présenter les caractéristiques suivantes :
- posséder une bonne résistance chimique aux différents bains chimiques et électrochimiques utilisés dans la réalisation du circuit imprimé, afin d'éviter toute piqûre des pistes.
- permettre, lors de l'opération de tampographie, une définition des bords, inférieure ou égale à 20 microns, compatible avec la largeur des pistes (inférieure à 250 microns).
- avoir une viscosité et une tension superficielle compatibles de la haute définition du circuit final et être également adaptées à la dureté et à la nature chimique du tampon de report.
- avoir une vitesse de séchage grande à une température relativement basse, afin d'être compatible avec le procédé industrialisé.

Les encres monocomposantes, de type polyester à base de phtalate de diallyle ainsi que les résines époxydes bicomposantes, répondent aux contraintes imposées.

Le tampon doit avoir une dureté et une forme adaptées à la surface à imager. Sa nature chimique doit être compatible avec la nature chimique de l'encre. Aucune adhérence résiduelle ne doit subsister après application sur le substrat. Par exemple, les silicones, matériaux couramment utilisés en tampographie, conviennent bien pour de telles applications. Le nombre de tampons pour réaliser une pièce dépend de sa forme et de sa complexité.

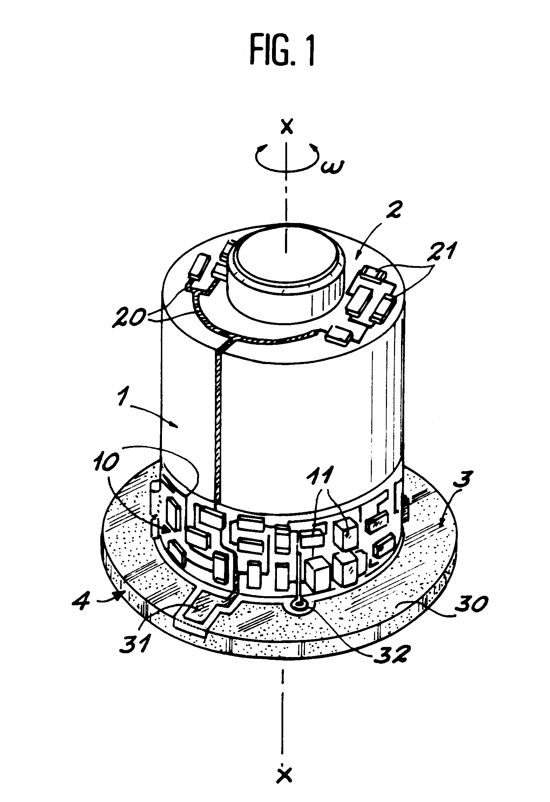

La figure 1 montre, à titre d'exemple, une pièce support cylindrique équipée de circuits imprimés obtenus selon le procédé précédemment décrit.

La pièce est de révolution autour d'un axe XX autour duquel elle peut être entraînée en rotation. Elle comporte en tant que support thermoplastique un corps cylindrique 1 délimité à la partie supérieure par un plan 2, et à la partie inférieure par le plan 3 d'une embase ou collerette 4. Les plans 2, 3 sont perpendiculaires à l'axe XX. Le plan supérieur 2 comporte un circuit imprimé 20 avec des composants 21. Le plan inférieur 3 comporte un circuit imprimé 30 formé essentiellement d'un dépôt de masse ou blindage et des éléments 31, 32. La surface cylindrique supporte un circuit imprimé 10 avec des composants 11.

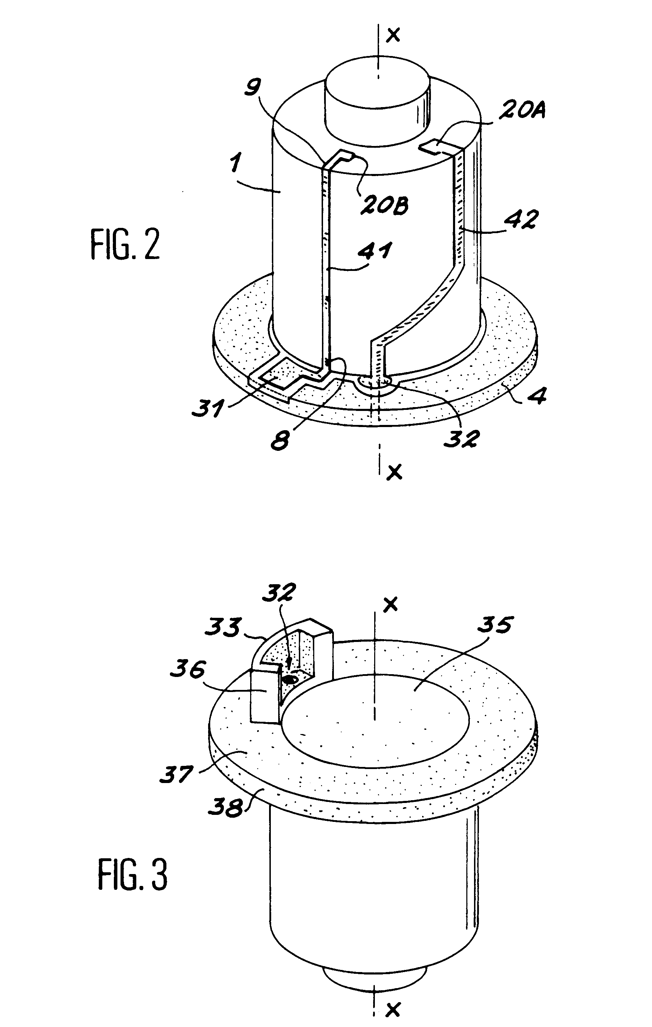

La pièce 1 est montrée en cours d'exécution sur la figure 2 démunie des composants électroniques 11, 21, et sur la figure 3 renversée. Outre les interconnexions entre composants, les circuits imprimés réalisent de plus des connexions :
- entre deux faces orthogonales, planes ou courbes, concaves 8 ou convexes 9,
- d'une face à l'autre d'une même plaque, par trou métallisé 32,
- entre éléments de la surface cylindrique 1,
- entre éléments d'une surface possédant un élément en relief, gênant pour imageage (ombre portée) aussi bien que pour le report des composants, dès lors que la hauteur de ce relief ne dépasse pas 7mm, par exemple face 2 de la figure 2.

La figure 2 montre des interconnexions entre les circuits imprimés, par exemple la liaison 42 entre 32 et 20A ou 41 entre 31 et 20B. Le diamètre du trou métallisé en 32 est fonction de l'épaisseur de la collerette 4 à traverser.

Les autres fonctions réalisées sont les suivantes :
isolement d'une patte d'interconnexion en 33 ; isolement d'un élément de commutation 31 ; blindage intérieur 35 et extérieurs 30,36,37,38 ; blindage d'une patte d'interconnexion 36 ; isolement d'un conducteur ou conducteur débordant sur une arête 31.

Entre les surfaces planes et la surface cylindrique il est nécessaire d'avoir un arrondi minimum à l'endroit 9 d'une arête en relief de 0,3mm et de 0, 5mm en 18 où l'arête est en creux.

Le procédé utilisé permet d'assurer l'interconnexion entre deux faces non coplanaires et réaliser des largeurs de pistes du même ordre de grandeur que celles obtenue pour des circuits plats, c'est-à-dire qui peuvent être inférieurs à 0,25mm avec des espacements également inférieurs à 0,25mm.

## Revendications

1. Procédé de réalisation de circuits imprimés par tampographie sur un support plastique comportant une surface cylindrique et des surfaces planes délimitant une pièce cylindrique dans lequel l'impression par tampographie s'effectue à l'aide de plusieurs tampons dont au moins un tampon (52) pour imprimer la surface cylindrique (53) opérant par roulement et un tampon pour imprimer une surface plane opérant par tamponnement et dans lequel des éléments de la pièce cylindrique sont utilisés comme repères le positionnement des tampons pour faire coïncider les raccords d'interconnexion des circuits imprimés revêtant des surfaces sécantes.

2. Procédé selon la revendication 1, caractérisé en ce que les surfaces du support plastique sont mises en état avant impression au moyen d'une attaque chimique qui produit de fines craquelures assurant une tenue mécanique élevée aux composants et aux pistes des circuits imprimés.

3. Procédé selon la revendication 1, caractérisé en ce que le report des composants sur des surfaces courbes de circuit imprimé obtenues s'effectue en utilisant une machine automatisée de collage et de positionnement.

4. Procédé selon la revendication 1, caractérisé en ce que le brasage des composants sur les circuits imprimés obtenus s'effectue au cours d'un chauffage par phase vapeur permettant d'obtenir une température parfaitement contrôlée compatible avec le matériau plastique du support.

5. Procédé selon la revendication 4, caractérisé en ce que la phase vapeur est produite par un composant flurorocarboné.

6. Procédé selon la revendication 5, caractérisé en ce que le composant fluorocarboné utilisé est à base de fluor inerte avec une température précise de la phase vapeur le 215°C±3°.

## Patentansprüche

1. Verfahren zur Herstellung gedruckter Schaltkreise durch Aufstempeln auf einen Kunststoffträger, der eine zylindrische Oberfläche und ebene Oberflächen besitzt, die ein zylindrisches Bauteil begrenzen, wobei der Druck mittels mehrerer Stempel erfolgt, von denen mindestens einer (52) zum Bedrucken der zylindrischen Oberfläche (53) als Rollstempel wirkt und einer zum Bedrucken einer ebenen Oberfläche per Stempelabdruck wirkt und wobei Elemente des zylindrischen Bauteils als Positioniermarken für die Stempel verwendet werden, um die Anschlüsse zur Verbindung der gedruckten Schaltkreise der einander schneidenden Oberflächen in Koinzidenz zu bringen.

2. Verfahren nach Anspruch 1, dadurch gekennzeichnet, daß die Oberflächen des Kunststoffträgers vor dem Bedrucken mit Hilfe einer chemischen Ätzung zubereitet werden, durch die Haarrisse erzeugt werden, die den Bauelementen und Leitbahnen der gedruckten Schaltkreise einen hohen mechanischen Halt verleihen.

3. Verfahren nach Anspruch 1, dadurch gekennzeichnet, daß das einsetzen der Bauelemente auf die gekrümmten gedruckten Schaltkreise unter Verwendung eines Klebe- und Positionierautomaten erfolgt.

4. Verfahren nach Anspruch 1, dadurch gekennzeichnet, daß das einlöten der Bauelemente in die gedruckten Schaltkreise während einer Erwärmung in der Dampfphase erfolgt, wodurch sich eine vollkommen kontrollierte Temperatur ergibt, die mit dem Kunststoffmaterial des Trägers kompatibel ist.

5. Verfahren nach Anspruch 4, dadurch gekennzeichnet, daß die Dampfphase durch eine Fluorkohlenstoffverbindung erzeugt wird.

6. Verfahren nach Anspruch 5, dadurch gekennzeichnet, daß die verwendete Fluorkohlenstoffverbindung eine Verbindung auf der Basis von inertem Fluor mit einer genauen Temperatur der Dampfphase von 215° ±3°C ist.

## Claims

1. A method for the production of printed circuits by tampography on a plastics support comprising a cylindrical surface and flat surfaces delimiting a cylindrical piece in which the impression by tampography is carried out by means of a plurality of stamps, at least one stamp (52) of which, to print the cylindrical surface (53) operates by rolling and one stamp, for printing a flat surface, operates by stamping and in which elements of the cylindrical piece are used as positioning marks for the stamps to cause the interconnection couplings of the printed circuits to coincide, covering secant surfaces.

2. A method according to Claim 1, characterised in that the surfaces of the plastics support are put in order before printing by means of a chemical attack which produces fine cracks ensuring a high mechanical behaviour with respect to the components and tracks of the printed circuits.

3. A method according to Claim 1, characterised in that the transfer of the components on curved surfaces of printed circuit which are obtained is carried out by using an automated machine for sticking and positioning.

4. A method according to Claim 1, characterised in that the brazing of the components on the printed circuits which are obtained is carried out in the course of a heating by vapour phase, allowing a perfectly controlled temperature to be obtained, which is compatible with the plastics material of the support.

5. A method according to Claim 4, characterised in that the vapour phase is produced by a fluoro-carbonated component.

6. A method according to Claim 5, characterised in that the fluoro-carbonated component which is used is based on inert fluorine with a precise temperature of the vapour phase of 215° C ± 3°.
